# EUROPÄISCHE PATENTSCHRIFT

(11) **EP 0 626 125 B1**
(45) Veröffentlichungstag und Bekanntmachung des Hinweises auf die Patenterteilung: **04.09.1996**
(21) Anmeldenummer: 94901892.3
(22) Anmeldetag: 26.11.1993
(51) Int. Cl.: H05K 13/04, H05K 3/22

(54) **GERÄT UND VERFAHREN ZUM BEDRUCKEN EINES SCHALTUNGSTRÄGERS**
PROCESS AND APPARATUS FOR PRINTING A PRINTED CIRCUIT BOARD
PROCEDE ET APPAREIL D'IMPRESSION DE CARTES A CIRCUIT IMPRIME

(30) Priorität: 27.11.1992 DE 4239995
(43) Veröffentlichungstag der Anmeldung: 30.11.1994
(73) Patentinhaber: Fritsch, Markus, D-92280 Kastl (DE)
(72) Erfinder: Fritsch, Adalbert, (DE)
(74) Vertreter: Mitscherlich, Hans, Dipl.-Ing.
(86) Internationale Anmeldenummer: EP9303326
(87) Internationale Veröffentlichungsnummer: WO9413125

(56) Entgegenhaltungen:
- EP-A- 0 233 125
- WO-A-86/03367
- WO-A-88/09601
- DE-A- 3 800 136

## Beschreibung

Die Erfindung bezieht sich auf ein Gerät oder Verfahren zum Bedrucken eines Schaltungsträgers nach dem Oberbegriff des Anspruchs 1 oder 13.

Es ist bekannt, eine Leiterplatte dadurch auf den pads mit Verbindungspaste zu bedrucken, daß auf die Leiterplatte eine Schablone mit Schablonenlöchern aufgelegt wird und auf die Schablone aufgetragene Verbindungspaste mittels eines Rakels verstrichen wird, wodurch die Verbindungspaste in die Schablonenlöcher hineingedrückt und auf die Leiterplatte aufgedruckt wird. Bei der Schablone handelt es sich dabei um eine Folie, die an ihrem Umfangsrand in einem Rahmen eingespannt ist. Bei einem solchen, in der DE-A-38 00 136 beschriebenen Gerät zum Bedrucken von Leiterplatten ist der Rahmen außerhalb der Oberfläche der Leiterplatte um eine horizontale Achse schwenkbar an einem Rahmenträger gelagert und somit mit der Schablone gegen die Leiterplatte schwenkbar, die auf einem Auflager des Rahmenträgers aufliegt.

Bei den bekannten Geräten ist der Rahmen größer bemessen als die Oberfläche der Leiterplatte, so daß die Schablone direkt auf die Leiterplatte aufgelegt werden kann und der die Schablone unterseitig überragende Rahmen freiliegt. Das Bedrucken der Leiterplatte erfolgt durch Verstreichen der Verbindungspaste mit dem Rakel auf der gesamten Oberfläche der Leiterplatte, d.h. es werden alle Anschlußstellen für zu bestückende elektronische Bauelemente in einem Arbeitsgang bedruckt. Die Schablonenlöcher sind in Anpassung an die Größe und Position der einzelnen Anschlußstellen für die Bauelemente vorgefertigt.

Es hat sich nun herausgestellt, daß es schwierig ist, Bauteile aus einer bereits bestückten Leiterplatte herauszulöten und die pads nach Reinigung vom Lot erneut mit Lötpaste zu versehen, so daß ein neues Bauteil (Reparatur) aufgebracht werden kann. Die Schwierigkeit besteht insbesondere darin, daß die übrigen auf der Leiterplatte befindlichen Bauteile nach oben vorstehen und den Wechselbereich seitlich begrenzen.

Der Erfindung liegt daher die Aufgabe zugrunde, eine Möglichkeit zu schaffen, das bisherige Schablonenn-Auftrag-Prinzip auch dann anwenden zu können, wenn einzelne Bauteile auf einer bereits bestückten Leiterplatte ausgewechselt werden sollen.

Bei einer bevorzugten Ausführungsform des erfindungsgemäßen Gerätes ist die Schablone an einem topfartigen Rahmen befestigt, dessen Außenabmessungen etwas über dem Bereich liegen, den vorzugsweise das auszuwechselnde Bauteil einnimmt und dessen Höhe etwas über der Höhe liegen kann, die durch die übrigen Bauteile auf der Leiterplatte vorgegeben ist.

Der Rahmen soll möglichst dünnwandig sein, da naturgemäß der Abstand zwischen den Bauelementen auf modernen Leiterplatten gering ist. Insoweit unterscheidet sich der hier verwendete Rahmen vom bekannten Rahmen bei dem keine Vorbedingungen bezüglich der Breite gegeben sind.

Es ist im Rahmen der Erfindung auch möglich, sowohl das in Anspruch 1 definierte, erfindungsgemäß Gerät als auch in Anspruch 13 definierte, erfindungsgemäße Verfahren zum vollständigen Bedrucken eines Schaltungsträgers zu benutzen.

Eine einfache Anwendung kann bei einem Gerät bestehen, welches eine Einspannung für die Leiterplatte aufweist und welches ferner eine mit Verstellelementen versehene Schienenführung aufweist, die über der Leiterplatte angeordnet ist. In diese Schienenführung kann der Rahmen eingespannt werden. In diesem Fall kann ein beliebiges Rakelelement verwendet werden, welches von der Vorrichtung zum Bedrucken getrennt ist.

Eine verbesserte Ausführungsform kann darin bestehen, daß die Leiterplatte in einen Kreuzschlitten eingespannt ist und das der Topf selber seinerseits auch in einer Führung, vorzugsweise einer Kreuzschlittenführung, eingespannt ist und relativ gegenüber der Leiterplatte verschoben werden kann.

Ferner ist es zweckmäßig, eine optische Justiervorrichtung vorzusehen, welche es gestattet, die Schablone auf das pad-Muster auf der Leiterplatte auszurichten.

In den Unteransprüchen sind Merkmale enthalten, die unter anderem die Vorrichtung zum Bedrucken verbessern, das Bedrucken vereinfachen, ein teil- oder vollautomatisches Bedrucken ermöglichen, das Justieren der Schablone verbessern und ein Bedrucken auch topographischer Schaltungsträger ermöglichen.

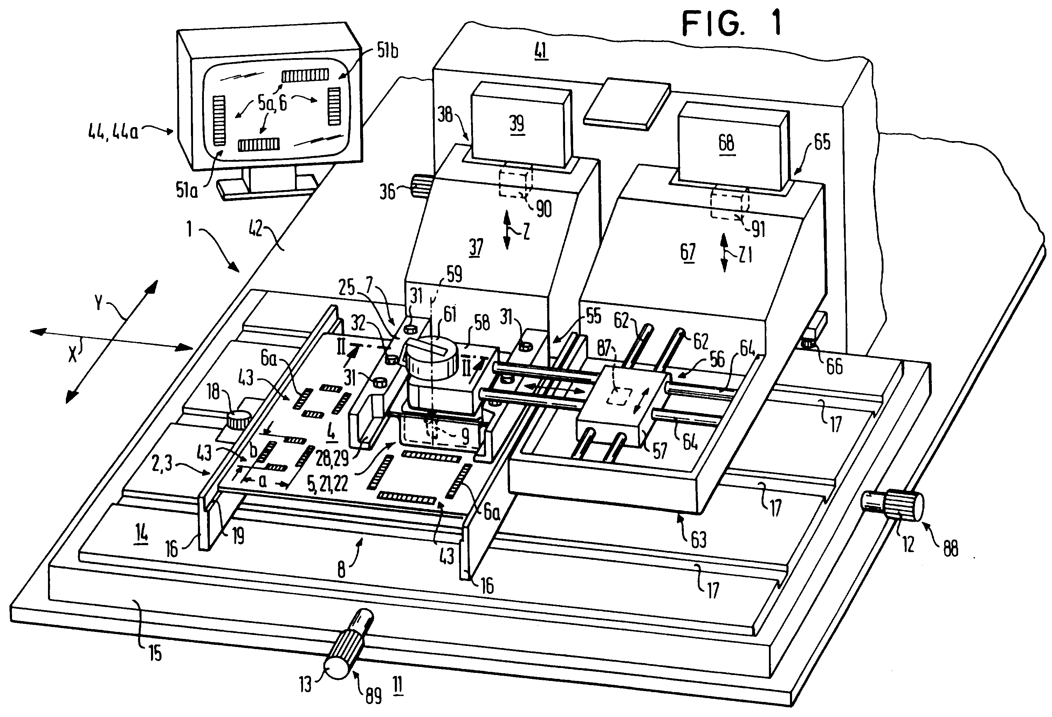

Nachfolgend werden die Erfindung und weitere durch sie erzielbaren Vorteile anhand von in einer vereinfachten Zeichnung dargestellten Ausführungsbeispielen näher erläutert. Es zeigt
Fig. 1 ein erfindungsgemäßes Gerät zum Bedrucken von Schaltungsträgern, z.B. Leiterplatten in perspektivischer Vorderansicht;
Fig. 2 den vertikalen Teilschnitt II-II in Fig. 1;
Fig. 3 den Teilschnitt III-III in Fig. 2;
Fig. 4 einen Rakel für das Gerät in der Ansicht gemäß dem Pfeil A in Fig. 2;
Fig. 5 einen Rakel in abgewandelter Ausgestaltung in der Vorderansicht;
Fig. 6 den Rakel nach Fig. 5 in der Seitenansicht von links;
Fig. 7 eine Bildaufnahmeeinrichtung des Gerätes in perspektivischer Vorderansicht;
Fig. 8 eine Schutzvorrichtung in perspektivischer Darstellung;
Fig. 9 einen Schaltungsträger in abgewandelter Ausgestaltung;
Fig. 10 einen Schaltungsträger in weiterer abgewandelter Ausgestaltung.

Die Hauptteile des Gerätes 1 sind eine erste Haltevorrichtung 2 mit einem Auflager 3 für eine Leiterplatte 4, einer Schablone 5 zum Bedrucken der Leiterplatte 4 mit Verbindungsstellen 6 an vorgenannten pads 6a, eine zweite Haltevorrichtung 7 zum Halten der Schablone 5 und eine Verstellvorrichtung 8 zur relativen Verstellung der Schablone 5 bezüglich der Leiterplatte 4. Die Verstellvorrichtung 8 ist bei der vorliegenden Ausgestaltung komplex und ermöglicht eine geführte Relativverstellung in mehreren Freiheitsgraden, nämlich parallel und senkrecht zur Leiterplatte 4. Bei der vorliegenden Ausgestaltung ist die erste Haltevorrichtung 2 in zwei horizontalen, rechtwinklig zueinander stehenden Verstellrichtungen X, Y verstellbar und in jeder Verstellposition positionierbar. Die Verstellrichtung X ist parallel und die Verstellrichtung Y senkrecht zur Bedienungsseite 11 angeordnet. Zum Verstellen dienen zwei Verstellelemente, vorzugsweise Feineinstellschrauben 12, 13, mittels denen eine horizontale Grundplatte 14 auf einem Basisrahmen 15 in den Verstellrichtungen X, Y verstellbar ist, wobei die Feineinstellschrauben 12, 13 im mittleren Bereich der vorderen und rechten Seitenfläche des Basisrahmens 15 angeordnet sind und mit ihren nicht dargestellten Gewindeenden an der Grundplatte 14 angreifen. Auf der Grundplatte 14 sind zwei aufrechte Halteleisten 16 in Führungsnuten 17 der Grundplatte 14 quer zu sich selbst verschiebbar gelagert und durch Feststellschrauben 18 feststellbar. Im Bereich der oberen Innenkanten der Halteleisten 16 ist jeweils eine Längsnut mit einer horizontalen Schulterfläche 19 vorgesehen, die das Auflager 3 für die Leiterplatte 4 bilden.

Die Schablone 5 ist vorzugsweise durch den Boden eines Topfes 21 gebildet, dessen Umfangswandung einen Rahmen 22 bildet, der beim Drucken von elektrischen Kontaktstellen, nämlich sogenannten pads 6a in ringförmiger Anordnung einen Führungsrahmen für einen Rakel 9 bildet mit dem auf die Schablone aufgetragene Verbindungspaste, z.B. Löt- oder Klebepaste, verstrichen und dabei durch Schablonenlöcher 5a auf die Leiterplatte 4 aufgetragen wird.

Die horizontale Querschnittsform des Topfes 21 ist an die Ringform der pads-Konfiguration angepaßt, beim vorliegenden Ausführungsbeispiel viereckig, nämlich rechteckig oder quadratisch. Die horizontale Querschnittsgröße des Topfes 21 bzw. Rahmens ist bezüglich ihrer Innenabmessung etwas größer bemessen, als die zugehörige Querschnittsabmessung a, b der pads-Konfiguration, wobei der Rahmen vorzugsweise dünnwandig ausgebildet ist, beim vorliegenden Ausführungsbeispiel etwa 1 bis 2 mm. Im Falle einer viereckigen Form können die Ecken innen und außen gerundet sein. Der Topf 21 weist an einer Seite oder an zwei gegenüberliegenden Seiten jeweils einen horizontalen Haltesteg 24 auf, mit dem oder denen er an der zweiten Haltevorrichtung 7 lösbar gehalten werden kann. Hierzu dienen ein oder zwei horizontale Haltearme 25, die an ihren Innenseiten einen horizontalen, längs nach vorne durchgehenden Aufnahmeschlitz 26 aufweisen, in die der Topf 21 mit den Haltestegen 24 von vorne horizontal einschiebbar ist. Vorzugsweise ist die untere Schlitzwandung 27 nach vorne verlängert, oder es sind im vorderen Eckenbereich der Haltearme 25 obere Ausnehmungen 28 vorgesehen, so daß sich Auflagerflächen 29 ergeben, auf die der Topf 21 handhabungsfreundlich aufgesetzt und dann eingeschoben werden kann. Zur Fixierung des Topfes 21 an den Haltearmen 25 sind auf jeder Seite eine oder zwei Feststellschrauben 31 von oben in die Haltearme 25 eingeschraubt, die gegen die Haltestege 24 schraubbar sind. Vorzugsweise ist auf jeder Seite, d.h. in jedem Haltearm 25 ein Zentrierstift 32 in einem vertikalen Führungsloch von oben eingesteckt, der in ein Zentrierloch 33 im zugehörigen Haltesteg 24 einfaßt. Vorzugsweise ist eines der Zentrierlöcher 33 in der Vertikalebene der Zentrierstifte 32 länglich geformt, um Toleranzen zwischen den Abständen der Zentrierlöcher 33 und der Zentrierstifte 32 anpassen zu können und ein leichtes Einschieben der Zentrierstifte von oben in die Zentrierlöcher 33 zu gewährleisten. In der zentrierten Position ist der Topf 21 so ausgerichtet, daß die pads-Reihen parallel zu den Verstellrichtungen X, Y ausgerichtet sind.

Die Haltearme 25 sind vertikal verstellbar, um zum einen den Topf 21 an unterschiedlich dicke Leiterplatten 4 anpassen zu können, und zum anderen den Topf 21 aus seinem Arbeitsbereich nach oben in eine Parkstellung verschieben zu können und dadurch mehr Freiraum zum Einlegen oder Einspannen der Leiterplatte 4 zu erhalten.

Die nach unten gerichtete Bewegung der vertikalen Verstellbewegung Z ist durch einen festen oder vorzugsweise einstellbaren Anschlag (nicht dargestellt) begrenzbar. Anstelle eines Anschlags kann auch ein Feststellelement, insbesondere auch eine Feststellschraube 36 zum Feststellen der vertikalen Verstellbewegung Z vorgesehen sein. Beim vorliegenden Ausführungsbeispiel sind die Haltearme 25 an einem Schlitten 37 nach vorne ragend und die Feststellschraube 36 seitlich angeordnet. Der Schlitten 37 ist in einer Vertikalführung 38 an einer Führungsschiene 39 vertikal verschiebbar, die frontseitig an einem Tragbock 41 befestigt ist, der rückseitig von dem Basisrahmen 15 angeordnet und an letzterem befestigt sein kann oder auf einer gemeinsamen Tischplatte 42 steht.

Die horizontale Querschnittsabmessung des Topfes 21 ist an die Größe der pads-Konfiguration für ein elektronisches Bauelement, insbesondere IC (nicht dargestellt), angepaßt. Die Leiterplatte 4 weist eine Vielzahl solcher Anschlußstellen 43 für elektronische Bauelemente auf. Infolgedessen beträgt die horizontale Querschnittsgröße des Topfes 21 nur einen Bruchteil der Größe der Leiterplatte 4.

Zum Bedrucken einer Leiterplatte 4 wird diese in die zweite Haltevorrichtung 7 eingesetzt bzw. eingespannt. Dann wird ein zur zugehörigen Anschlußstelle 43 passender Topf 21 mit dem Schlitten 37 auf die Leiterplatte 4 abgesenkt und nach den pads 6a ausgerichtet, was durch ein horizontales Verstellen der Leiterplatte 4 in der X- und/oder Y-Richtung erfolgt. Es kann alternativ eine der beiden durch die Feineinstellschrauben 12, 13 gebildeten Verstelleinrichtungen oder eine zusätzliche Verstelleinrichtung eine horizontale Drehverstellung umfassen, so daß die Koordinaten der Leiterplatte 4 mit den Verstellrichtungen X, Y in Übereinstimmung gebracht werden können.

Insbesondere bei kleinen pads 6a, wie sie bei SMD (small mounted device) üblich sind, namlich mehrere hundert pads 6a pro Kantenlänge der Anschlußstelle 43, ist es vorteilhaft, dem Gerät 1 eine optische Hilfseinrichtung 44, insbesondere mit einer optischen Vergrößerung, zuzuordnen, um die Schablone 5 mit ihren Schablonenlöchern 5a genau über bzw. auf den pads 6 ausrichten zu können.

Beim vorliegenden Ausführungsbeispiel umfaßt die optische Hilfseinrichtung 44 eine Bildaufnahme- und Bildabgabeeinrichtung 44a, 44b, die eine Kamera zur Bildaufnahme und einen Monitor 46 zur Darstellung des vorzugsweise vergrößerten Bildes aufweisen kann. Beim vorliegenden Ausführungsbeispiel weist die Bildaufnahmevorrichtung ein oder zwei Prismen 47 auf, die als kleines und raumgünstiges Bauteil über einem oder zwei vorzugsweise einander diametral gegenüberliegende Eckenbereiche der pads-Konfiguration schiebbar sind und das Bild mittels eines oder zwei Lichtleiter 48 weiterleiten. Es ist auch möglich, das oder die Prismen 47 unmittelbar an eine Kamera anzuordnen. Das Bild wird in der Bilddarstellungseinrichtung 45 elektronisch verarbeitet und auf dem Monitor 46 so groß dargestellt, daß eine unzureichende und die richtige Position der Schablone 5 bezüglich der pads 6a gut erkennbar ist, wie es das oder die Bilder 51a, 51b des Monitors 46 zeigen, die vorzugsweise vergrößerte Eckenbereiche der pads-Konfiguration darstellen. Wenn die Schablonenlöcher 5a sich genau über den pads 6a befinden, ist die Position richtig. Dies kann mit den Feineinstellschrauben 12, 13 genau justiert werden.

Das das oder die Prismen 47 oder Objektive 47a tragende Bauteil 42 der Bildaufnahme- und Bilddarstellungseinrichtung 45 ist in einer nur andeutungsweise dargestellten Führung 53 vertikal oder horizontal, insbesondere zwischen einer vorderen Arbeitsstellung, in der es sich über dem Topf 21 befindet und einer hinteren Parkstellung, in der es den Bereich des Topfes freigibt, verstellbar. Beim vorliegenden Ausführungsbeispiel erfolgt dies manuell. Es ist jedoch auch möglich, für diese Verstellbewegung eine Antriebsvorrichtung 53a mit einem Antriebsmotor vorzusehen, der durch eine Steuereinrichtung teil- oder voll ansteuerbar ist, um das Bauteil 49 zwischen seiner Parkstellung und seiner Arbeitsstellung zu den Zeitpunkten zu verfahren, an denen es jeweils stehen soll.

In der auf der Leiterplatte 4 aufgesetzten Position des Topfes 21 kann das Bedrucken erfolgen. Hierzu wird der Rakel 9 über den Schablonenlöchern 5a in Umfangsrichtung 50 der Konfiguration unter leichtem nach unten gerichtetem Druck gegen die Schablone 5 verschoben, wobei die im Topf 21 befindliche Druck- bzw. Verbindungsmasse in die Schablonenlöcher 5a eingedrückt und somit die Leiterplatte 4 bedruckt wird. Danach wird der Topf 21 nach oben verfahren, und die Leiterplatte 4 kann entnommen sowie eine andere zu bedruckende Leiterplatte 4 wieder eingesetzt werden.

Das Verschieben des Rakels 9 kann von Hand erfolgen, wobei die Innenfläche 22a des Rahmens 22 eine seitliche Führung für den Rakel 9 bilden kann. Es ist von Vorteil, dem Rakel 9 eine Führungseinrichtung 55 zuzuordnen, die ihn in der horizontalen Ebene führt, so daß seine vertikale Position bezüglich der Schablone 5 und somit auch der vertikale Druck, mit dem der Rakel 9 gegen die Schablone 5 drückt, im wesentlichen immer gleich ist. Beim vorliegenden Ausführungsbeispiel ist hierzu eine sogenannte Kreuzführung 56 mit einem Kreuzschlitten 57 vorgesehen. Der Rakel ist in einem Führungskopf 58 um eine vertikale Drehachse 59 drehbar gelagert, wobei für ein manuelles Drehen ein Drehkopf 61 vorzugsweise über dem Führungskopf 58 angeordnet ist, mit dem der Rakel 9 drehbar ist. Der Rakel 9 wird in einer Stellung, in der sein Rakelsteg 9a quer zur Reihe der pads 6a steht, in Längsrichtung der Reihe bzw. in Umfangsrichtung 50 der Konfiguration verschoben. Bei einer mehreckigen, insbesondere viereckigen Konfiguration wird der Rakel 9 im Eckenbereich um den vorhandenen Winkel der Konfiguration gedreht, so daß der Rakelsteg 9a immer quer zur Reihe bzw. Bewegungsrichtung 50 steht.

Zur Verbesserung der seitlichen Führung ist beim vorliegenden Ausführungsbeispiel auf dem Schaft 9b des Rakels 9 ein vorzugsweise kreisrundes Führungsstück 9c angeordnet, das vorzugsweise durch den Außenring eines auf dem Schaft 9b sitzenden Kugellagers gebildet ist. Das Führungsstück 9c ist so groß bemessen, daß bei seiner Anlage an der Innenfläche 22a des Rahmens 22 die Seitenfläche 9d des Rakels 9 einen kleinen Abstand von dem Rahmen 22 aufweist.

Beim vorliegenden Ausführungsbeispiel ist der Kreuzschlitten 57 auf einer oder zwei Führungsstangen 62 vorzugsweise mittels Kugelführungen verschiebbar, die sich längs der X-Richtung erstrecken und an einem Träger 63 gehalten sind. Der Führungskopf 58 ist außerdem mittels einer oder zwei paralleler Führungsstangen 64 im Führungskopf 58 horizontal verschiebbar gelagert, die sich rechtwinklig zu den Führungsstangen 62 erstrecken. Der Führungskopf 58 ist somit mit dem Rakel 9 in der Vertikalen positioniert und in der Horizontalen im vorhandenen Bewegungsbereich der Kreuzführung 56 wahlweise verschiebbar.

Der Träger 63 ist - wie der Schlitten 37 - in einer Vertikalführung 65 am Tragbock 41 vertikal verschiebbar geführt und durch einen vorzugsweise z.B. verstellbaren Anschlag 66 in seiner nach unten gerichteten Bewegung begrenzt. Dabei ist der Träger 63 rückseitig als Schlitten 67 ausgebildet, der an einer am Tragbock 41 befestigten vertikalen Führungsschiene 68 vertikal verschiebbar ist, wobei er sich vorzugsweise neben und zwar beim vorliegenden Ausführungsbeispiel rechts neben dem Schlitten 37 befindet. Der Träger 63 bzw. der Schlitten 67 weist frontseitig als Schutzkasten mit einem lösbaren, nicht dargestellten Deckel ausgebildet, in dem der Kreuzschlitten 57 geschützt verschiebbar ist, wobei die Führungsstangen 64 eine Öffnung auf der dem Führungskopf 58 zugewandten Seite durchragen.

Insbesondere für mehreckige pads-Konfigurationen mit geraden Reihen der pads 6a ist es von Vorteil, dem Drehkopf 61 eine lösbare Feststellvorrichtung zuzuordnen, die ihn gegen Verdrehung sichert, so daß der Rakelsteg 9a senkrecht zur Bewegungsrichtung 50 bzw. Reihe steht. Beim vorliegenden Ausführungsbeispiel ist hier eine lösbare Verrastungsvorrichtung 71 vorgesehen und in den Drehkopf 61 integriert. Sie weist einen vorzugsweise durch eine Drucktaste 72 gebildetes Verrastungs-Löseelement auf, das vorzugsweise zum Lösen der Verrastung vertikal heruntergedrückt wird und sich insbesondere an der Oberseite des Drehkopfes 61 befindet. Hierdurch ist ein handhabungsfreundliches Lösen der Verrastung bei der manuellen Verschiebung des Rakels 9 möglich. Die Verrastungseinrichtung 71 weist ein bewegliches Verrastungsglied 73 auf, das in der gewünschten Drehstellung in eine Verrastungsausnehmung 74 unter der Wirkung der Kraft einer Feder 75 einrastet. Vorzugsweise ist das bewegliche Verrastungsglied 73 und die Drucktaste 72 ein winkel- oder hakenförmiges Bauteil, das vertikal schwenkbar am Drehkopf 61 gelagert ist und dabei vorzugsweise im Drehkopf 61 teilweise versenkt ist. Die Verrastungsausnehmung 74 ist am Führungskopf 58 oder einem mit diesem fest verbundenen Bauteil, hier einen den Schaft 9b umgebenden Ring 36 gebildet, der unterhalb des Drehkopfes 61 angeordnet ist. Die Anzahl der Verrastungsausnehmungen 74 ist an die vorhandene Anzahl der Ecken der pads-Konfiguration anzupassen, hier vier Stück Verrastungsausnehmungen 74.

Der Rakel 9 ist vorzugsweise vertikal verschiebbar gelagert und durch die Kraft einer Feder in seine untere Arbeitsstellung beaufschlagt. Bei der vorliegenden Ausgestaltung ist der Schaft 9b in der Bohrung des Drehkopfes 61 vertikal verschiebbar gelagert und durch eine zwischen dem Drehkopf 61 und dem Führungsstück 9c eingespannte Druckfeder vorgespannt. Die vertikalen Bewegungen Z und Z.1 der Schlitten 37 und 67 sind nach unten durch die Schrauben 36, 66 so begrenzt, daß bei auf der Leiterplatte 4 aufstehender Schablone 5 der auf der Schablone 5 aufstehende Rakel 9 um ein kleines Maß M gegen die Federkraft nach oben verschoben und somit durch die Federkraft gegen die Schablone 5 beaufschlagt ist. Das Maß M ist vorzugsweise größer bemessen als die Dickenunterschiede üblicher Leiterplatten 4, so daß eine Neueinstellung bei verschiedenen Leiterplatten nicht erforderlich ist.

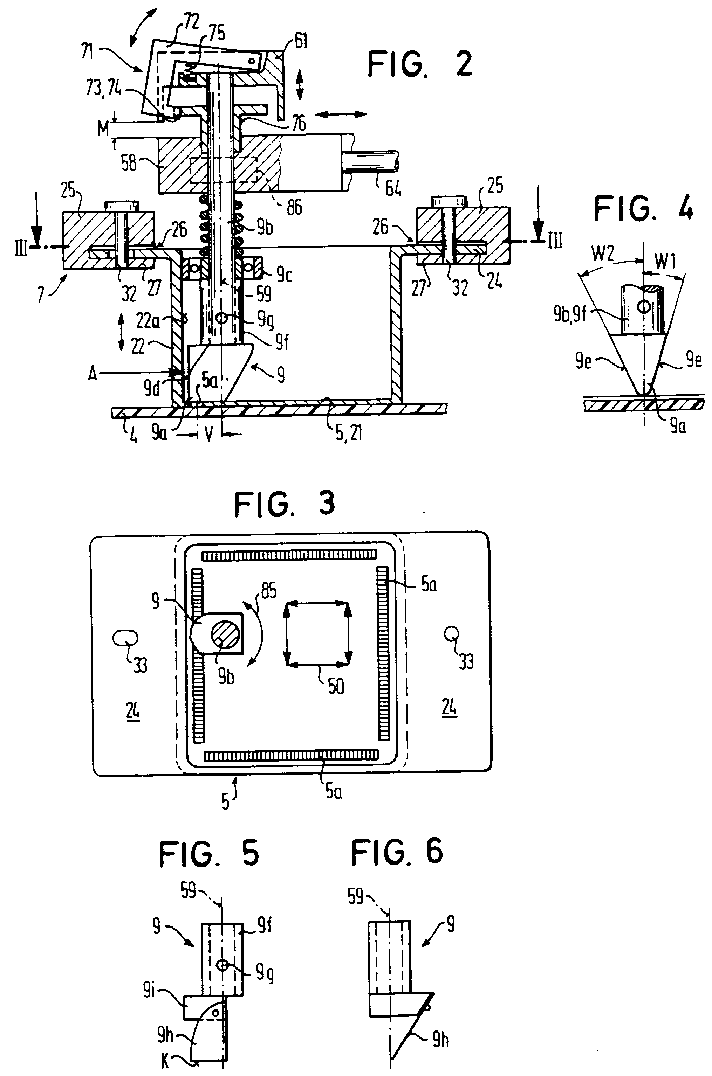

Die gegebenenfalls gerundete Streichkante K des Rakelstegs 9a ist bezüglich seiner Drehachse 59 exzentrisch angeordnet, so daß sie innen in der Nähe der Drehachse 59 endet. Hierdurch ist ein sauberes Verstreichen beim Drehen des Rakels 9 im Eckenbereich gewährleistet, wobei die Anordnung so getroffen wird, daß in der Streichstellung die Schablonenlöcher 5a bezüglich der Drehachse 59 versetzt sind, siehe Versetzungsmaß V in Fig. 2.

Bei der Ausgestaltung gemäß Fig. 2 bis 4 ist der Rakelsteg 9 keilförmig geformt, wobei seine Keilflächen 9e gleiche oder vorzugsweise unterschiedliche Winkel W1, W2 aufweisen können, wodurch eine Anpassung an das zu verstreichende Verbindungsmittel möglich ist. Der Rakelsteg 9a kann aus Kunststoff bestehen. Er kann zwecks Auswechslung lösbar am Schaft 9b befestigt sein, hier mittels einer nach oben ragenden Hülse 9f, die durch eine Schraube 9g oder dergleichen am Schaft 9b fixierbar ist.

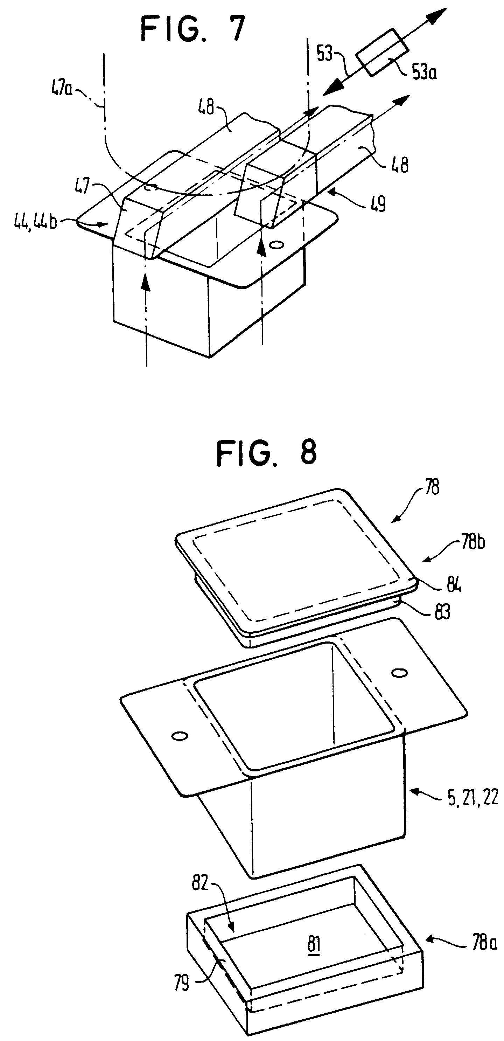

Bei der Ausgestaltung nach Fig. 5 und 6 weist der Rakel 9 anstelle eines massiven Steges 9a einen vorzugsweise federelastischen Streifen 9h, insbesondere aus Metall auf, der sich gerade erstrecken kann und hier an einer Schrägfläche eines Rakelfußes 9i befestigt, z.B. verschraubt oder vernietet ist. Die Streichkante K befindet sich in oder nahe der Drehachse 59, wobei sie ebenfalls in oder nahe der Drehachse 59 endet.

Dem Gerät 1 sind mehrere unterschiedliche Schablonen 5, Töpfe 21 oder Rahmen 22 zugeordnet, die wahlweise in die zweite Haltevorrichtung 7 einsetzbar sind und bezüglich ihrer Form und/oder Anzahl der Schablonenlöcher 5a und/oder horizontal ihrer Querschnittsform und/oder -größe an die Form und/oder Größe und/oder Anzahl und/oder Konfiguration der pads angepaßt sind.

Bei einem Topf 21 handelt es sich wegen der Schablone 5 um ein empfindliches Bauteil. Deshalb ist gemäß Fig. 8 ein Schutzkasten 78 für den Topf vorgesehen, der vorzugsweise ein Kastenunterteil 78a und einen Deckel 78b umfaßt und aus Kunststoff bestehen kann (Kunststoff-Spritzteil). Vorzugsweise besteht das Kastenunterteil 78a aus einem niedriger als der Topf 21 bemessenen Rahmen 79 mit Boden 81, in dessen Ausnehmung 82 der Topf 21 einsetzbar ist. Der Deckel 78b ist vorzugsweise ein Flachdeckel, der mit einem unterseitigen Ansatz 83 in den Topf 21 einsetzbar ist und mit einem seitlichen Rand 84 auf dem Topfrand aufliegt.

Im folgenden werden die wesentlichen Freiheitsgrade des Gerätes 1 aufgelistet:
a) Horizontale Relativbewegung zwischen der Leiterplatte 4 und der Schablone 5, hier der Leiterplatte 4, längs den Koordinaten-Richtungen X, Y.
b) Vertikale Relativbewegung zwischen der Leiterplatte 4 und der Schablone 5, hier der Schablone 5.
c) Horizontale Drehbewegung 85 des Rakels 9.
d) Horizontale X-Y-Bewegung bzw. Umlaufbewegung 50 des Rakels 9
e) Vertikale Bewegung 86, Z.1 des Rakels 9 relativ zur Schablone 5 und/oder zu seinem Träger (Drehkopf 61).

Das Gerät 1 eignet sich um Bedrucken der Leiterplatte 4 sowohl am nur einer oder einzelnen als auch an allen Anschlußstellen 43. Im ersten Fall eignet sich das Gerät 1 vorzüglich zum Reparieren von Leiterplatten 4, z.B. zum Austausch eines oder mehrerer Bauelemente. Hierzu wird die Verbindungsmasse gelöst, was bei Verwendung einer Lötmasse durch Erhitzen erfolgen kann, das Bauteil entfernt, die Anschlußstelle 43 gereinigt und dann in vorbeschriebener Weise neu bedruckt, wonach ein neues passendes Bauteil aufgesetzt und mit der aufgedruckten Verbindungsmasse und den pads 6a verbunden wird, bei Verwendung einer Lötpaste durch Löten. Dabei ermöglicht die Erfindung eine gezielte Arbeit an der zu reparierenden Stelle, wobei benachbarte Bauelemente bzw. Anschlußstellen 43 nicht behindert werden und auch die Arbeiten an der zu reparierenden Stelle nicht behindern.

Es ist auch möglich, die Leiterplatte 4 insgesamt zu bedrucken. Im Unterschied zu bekannten Verfahren, bei denen alle Anschlußstellen 43 der Leiterplatte 4 in einem Arbeitsgang des Rakels 9 bedruckt werden, wird beim erfindungsgemäßen Verfahren die Schablone 5 bzw. die sie aufweisende Einrichtung zum Drucken, zu einer Anschlußstelle 43 geführt und das Bedrucken mit dem Rakel 9 ausgeführt, wonach die oder eine ausgetauschte Schablone 5 zur nächsten Anschlußstelle 43 geführt und die Bedruckung entsprechend ausgeführt werden kann, bis alle Anschlußstellen 43 bedruckt sind. In einem solchen Fall ist der Bewegungsbereich der Verstellvorrichtung 8 so groß zu bemessen, daß mit der Schablone 5 alle Anschlußstellen 43 erreicht werden können.

Im Rahmen der Erfindung ist es möglich, die gegebenenfalls schrittweise Drehbewegung 85 des Rakels 9 und/oder seine horizontale Vorschub- bzw. Umlaufbewegung 50 nicht manuell sondern automatisch mittels einer Antriebseinrichtung mit einem Antriebsmotor auszuführen. Ein solcher Antrieb mit Motor kann z.B. dem Kreuzschlitten 57 und dem Führungskopf 58 zugeordnet sein und ist andeutungsweise dargestellt und mit 86, 87 bezeichnet. Diesen Antrieben ist eine zugehörige Steuereinrichtung zugeordnet, die halbautomatisch, z.B. auf ein manuelles Signal hin, oder auch vollautomatisch funktionieren kann.

Im Rahmen der Erfindung ist es auch möglich, einzelne, weitere oder alle Bewegungen des jeweiligen Teils des Geräts 1, nämlich die Bewegungen längs den Bewegungsrichtung X, Y, die Hin- und Herbewegung des Bauteils 49, die Auf- und Abbewegung der Schablone 5 bzw. des Topfes 21 und die vorerwähnten Bewegungen des Rakels 9 (Drehbewegung, horizontale Bewegung, vertikale Bewegung) teil- oder vollautomatisch auszuführen, wozu für die jeweilige Bewegung ein angedeuteter Antrieb 88, 89, 53a, 90, 91 mit einem Antriebsmotor vorzusehen ist, die vorbeschriebenen Bewegungen andeutungsweise dargestellt, die in nicht dargestellter Weise mit einer jeweils zugehörigen oder gemeinsamen Steuereinrichtung steuerbar sind.

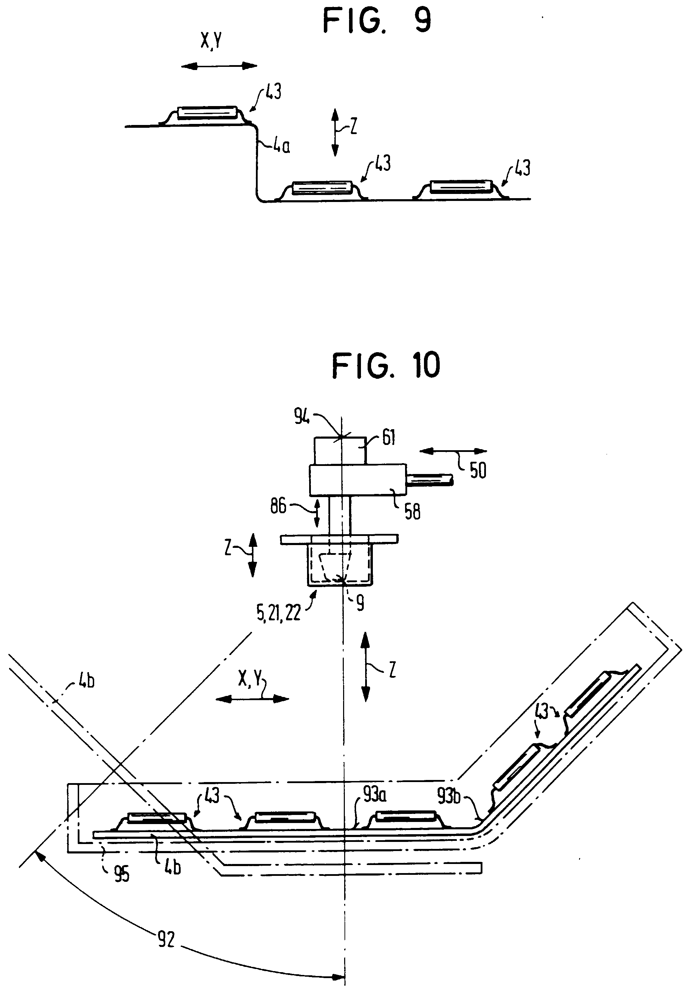

Die Erfindung ermöglicht es auch, anstelle von ebenen Leiterplatten 4 dreidimensionale Schaltungsträger 4a, 4b (Fig. 9 und 10) lokal oder insgesamt mit Verbindungsstellen zu bedrucken bzw. zu reparieren. Aufgrund der jeweils lokalen Bedruckung können Schaltungsträger bedruckt werden, deren Anschlußstellen 43 in unterschiedlichen Höhen angeordnet sind. Ein solcher Schaltungsträger 4a mit insbesondere vertikalen Stufen ist in Fig. 9 schematisch in der Seitenansicht dargestellt. Bei einem solchen dreidimensionalen bzw. topographischen Schaltungsträger 4a kann es sich auch um eine Leiterplatte handeln, die eine von einer ebenen Form abweichende Form aufweist, z. B. förmig geformt ist, wie es in Fig. 9 und 10 dargestellt ist. In diesem Falle bedarf es eines weiteren Freiheitsgrades 92, der durch die geneigt oder quer zueinander stehenden Oberflächenbereiche 93a, 93b bzw. Anschlußstellen 43 vorgegeben ist. Gemäß Fig. 10 läßt sich dies durch eine um eine insbesondere horizontale Schwenkachse 94 schwenkbare Anordnung des den Schaltungsträger 4b haltenden Halters 94 erreichen, was in Fig. 10 mit strichpunktierter Darstellung des Schaltungsträgers 4b verdeutlicht ist. Auch eine solche Bewegung läßt sich durch einen zugehörigen Antrieb mit Antriebsmotor (nicht dargestellt) teil- oder vollautomatisch ausführen und entsprechend steuern. Bei dem Halter 95 für den Schaltungsträger 4b kann es sich auch um ein den Schaltungsträger 4b aufnehmendes Gehäuseteil handeln. Die Erfindung ermöglicht es somit auch, Schaltungsträger bzw. Leiterplatten im in einem Gehäuse montierten Zustand lokal oder ganz zu bedrucken oder zu reparieren. Bei Bedrucken eines räumlichen Schaltungsträgers 4a, 4b ist immer dann, wenn zwei Anschlußstellen 43 einander folgend bedruckt werden sollen, die sich auf zueinander versetzten Oberflächenbereichen befinden, eine Relativverstellung zwischen dem Schaltungsträger 4a, 4b und der Schablone 5 bzw. der Einrichtung zum Bedrucken auszuführen um diese Teile in die erforderliche Arbeitsstellung zueinander zu bringen, und zwar gemäß Fig. 9 eine Relativverstellung im Freiheitsgrad Z und gemäß Fig. 10 eine Relativverstellung (Schwenkung des Schaltungsträgers 4b mit Halter) im Freiheitsgrad 92 und zusätzlich eine Verstellung der Schablone 5 im Freiheitsgrad Z.

## Patentansprüche

1. Gerät (1) zum Bedrucken eines Schaltungsträgers (4, 4a, 4b) mittels einer Schablone (5) und einem Rakel (9), bestehend aus einem Auflager (3) zum Positionieren des Schaltungsträgers (4) und einem Rahmen (22), an dem die Schablone (5) gehalten ist,
dadurch gekennzeichnet,
daß die Querschnittsabmessung des Rahmens (22) kleiner ist als die die Anschlußstellen (43) für elektronische Bauelemente aufweisende Oberfläche des Schaltungsträgers (4) und eine Verstellvorrichtung (2, X, Y) vorgesehen ist für eine relative Verstellung oder Justierung zwischen Schaltungsträger (4, 4a, 4b) und Rahmen (22) parallel zu der Oberfläche.

2. Gerät nach Anspruch 1,
dadurch gekennzeichnet,
daß der Rahmen (22) innen an die Größe der Anschlußstelle (43) und vorzugsweise auch an deren Form angepaßt ist, insbesondere geringfügig größer ist.

3. Gerät nach Anspruch 2,
gekennzeichnet durch eine Verstellvorrichtung (Z) für eine Relativverstellung zwischen Schaltungsträger (4, 4a, 4b) und Rahmen (22) quer, insbesondere rechtwinklig, zur Fläche der Anschlußstelle (43).

4. Gerät, insbesondere nach einem der vorherigen Ansprüche,
dadurch gekennzeichnet,
daß dem Rahmen (22) und dem Rakel (9) eine jeweils eigene oder eine gemeinsame Haltevorrichtung (7, 58) zugeordnet ist.

5. Gerät, insbesondere nach einem der vorherigen Ansprüche,
dadurch gekennzeichnet,
daß der Rakel (9) relativ zur Schablone (5) um seine Achse (59) drehbar und/oder vertikal verschiebbar und/oder horizontal verschiebbar und vorzugsweise dabei auf einer insbesondere geschlossenen Schleife (50) verschiebbar gehalten ist, deren Form und Größe der Form und Größe der pads-Konfiguration entspricht.

6. Gerät nach Anspruch 5,
dadurch gekennzeichnet,
daß der drehbare Rakel (9) in einer oder mehreren, insbesondere vier Drehstellungen lösbar arretierbar ist.

7. Gerät nach Anspruch 5 oder 6,
dadurch gekennzeichnet,
daß der Rakel (9) durch eine Vorspannkraft gegen die Schablone (5) beaufschlagt ist.

8. Gerät nach einem der Ansprüche 5 bis 7,
dadurch gekennzeichnet,
daß ihm eine Führungseinrichtung (9c, 22) zum Verschieben auf der Schleife (50) zugeordnet ist.

9. Gerät nach einem der vorherigen Ansprüche,
dadurch gekennzeichnet,
daß der Rahmen (22) und vorzugsweise auch der Rakel (9) jeweils im zugehörigen Halter (7, 65) zwischen einer Arbeitsstellung auf dem Schaltungsträger (4) und einer insbesondere nach oben verstellten Parkstellung verstellbar ist.

10. Gerät nach einem der vorherigen Ansprüche,
dadurch gekennzeichnet,
daß ihm eine Vergrößerungseinrichtung (44) zur vergrößerten Bild-Darstellung eines oder zwei vorzugsweise einander gegenüberliegender Teilbereiche der Schablonenlöcher (5a) zugeordnet ist, insbesondere mit einer über den Rahmen (22) angeordneten Bild-Aufnahmeeinrichtung (44b) und einem Monitor (44a)

11. Gerät nach Anspruch 10,
dadurch gekennzeichnet,
daß die Bild-Aufnahmeeinrichtung (44b) oder eine Vergrößerungsoptik (47a) in eine den Raum oberhalb des Rahmens (22) freigebenden Parkstellung verschiebbar gelagert ist.

12. Gerät insbesondere nach einem der vorherigen Ansprüche,
dadurch gekennzeichnet,
daß bei Benutzung eines räumlichen Schaltungsträgers (4a, 4b) mit quer oder schräg zueinander angeordneten Flächen (93a, 93b) für Anschlußstellen (43) die Haltevorrichtung für den Schaltungsträger (4b) oder die Einrichtung (5, 9) zum Bedrucken relativ zueinander schwenkbar und in der jeweiligen Schwenkstellung positionierbar ist.

13. Verfahren zum Bedrucken eines Schaltungsträgers (4, 4a, 4b) mit Verbindungspaste an Anschlußstellen (43) für elektronische Bauelemente, bei dem mittels eines Rakels (9) die Verbindungspaste auf einer an einem Rahmen (22) gehaltenen Schablone (5) durch Schablonenlöcher (5a) auf den Schaltungsträger (4, 4a, 4b) gestrichen wird,
dadurch gekennzeichnet,
daß unter Benutzung eines Rahmens (22), dessen Größe nur einen Teilbereich der die Anschlußstellen (43) aufweisenden Oberfläche des Schaltungsträgers entspricht, letzterer lokal bedruckt wird und dann wenigstens ein oder alle weiteren lokalen Teilbereiche (43) nacheinander entsprechend bedruckt werden.

## Claims

1. Apparatus (1) for printing a circuitry carrier (4,4a,4b) by means of a stencil (5) and a wiper (9), consisting of a support (3) for positioning the circuitry carrier (4) and a frame (22) on which the stencil (5) is held,
characterised in that,
the cross-sectional dimensions of the frame (22) are smaller than the surface of the circuitry carrier (4) having the connection points (43) for electronic components, and an adjustment device (2,X,Y) is provided for a relative displacement or adjustment between circuitry carrier (4,4a,4b) and frame (22) parallel to the surface.

2. Apparatus according to claim 1,
characterised in that,
the frame (22) is internally adapted to the size of the connection point (43), and is preferably also adapted to the form thereof, in particular slightly larger.

3. Apparatus according to claim 2,
characterised by
a displacement device (Z) for a relative displacement between circuitry carrier (4,4a,4b) and frame (22) transversely of, in particular at right angles to, the surface of the connection point (43).

4. Apparatus in particular according to any preceding claim,
characterised in that,
respective mounting devices or a common mounting device (7,58) are/is associated with the frame (22) and the wiper (9) .

5. Apparatus in particular according to any preceding claim,
characterised in that,
relative to the stencil (5), the wiper (9) is mounted rotatably about its axis (59) and/or vertically displaceably and/or horizontally displaceably and preferably thereby displaceably on an in particular closed loop (50) whose form and size correspond to the form and size of the pad configuration.

6. Apparatus according to claim 5,
characterised in that,
the rotatable wiper (9) is releasably fixable in one or more, in particular four, rotational positions.

7. Apparatus according to claim 5 or 6,
characterised in that,
the wiper (9) is urged against the stencil (5) by a biasing force.

8. Apparatus according to any of claims 5 to 7,
characterised in that,
there is associated therewith a guide device (9c,22) for displacement on the loop (50).

9. Apparatus according to any preceding claim,
characterised in that,
the frame (22) and preferably also the wiper (9) is or are each in the associated mount (7,65) displaceable between a working position on the circuitry carrier (4) and an in particular upwardly displaced parking position.

10. Apparatus according to any preceding claim,
characterised in that,
there is associated therewith a magnification device (44) for representing a magnified image of one or two, preferably opposing, parts of the stencil holes (5a), in particular having an imaging device (44b) arranged above the frame (22) and a monitor (44a).

11. Apparatus according to claim 10,
characterised in that,
the imaging device (44b) or a magnifying optical system (47a) is displaceably mounted in a space above the parking position freeing the frame (22).

12. Apparatus in particular according to any preceding claim,
characterised in that,
with the employment of a three-dimensional circuitry carrier (4a,4b), having mutually transversely or obliquely arranged surfaces (93a,93b) for connection points (43), the mounting device for the circuitry carrier (4b) or the printing device (5,9) is pivotable relative to one another and positionable in the relevant pivot disposition.

13. Process for printing a circuitry carrier (4,4a,4b) with bonding paste at connection points (43) for electronic components, in which, by means of a wiper (9), the bonding paste on a stencil (5) held on a frame (22) is spread through stencil holes (5a) onto the circuitry carrier (4,4a,4b),
characterised in that,
with use of a frame (22) whose size corresponds to only a part of the surface of the circuitry carrier having the connection points (43), the circuitry carrier is locally printed and then at least one or all further local parts (43) are correspondingly printed one after another.

## Revendications

1. Appareil (1) pour l'impression d'un support de circuit (4, 4a, 4b) au moyen d'un patron (5) et d'une racle (9), comprenant un appui (3) pour le positionnement du support de circuit (4) et un cadre (22) dans lequel le patron (5) est maintenu,
caractérisé par le fait que la taille en section du cadre (22) est plus petite que la surface du support de circuit (4) présentant les emplacements de connexion (43) pour des composants électroniques et qu'il est prévu un dispositif de déplacement (2, X, Y) pour un déplacement ou réglage relatif entre le support de circuit (4, 4a, 4b) et le cadre (22) parallèlement à la surface.

2. Appareil suivant la revendication 1,
caractérisé par le fait
que le cadre (22) est adapté intérieurement à la taille et de préférence également à la forme de l'emplacement de connexion (43), en étant en particulier légèrement plus grand que l'emplacement de connexion.

3. Appareil suivant la revendication 2,
caractérisé par un dispositif de déplacement (Z) pour le déplacement relatif entre le support de circuit (4, 4a, 4b) et le cadre (22) transversalement et en particulier perpendiculairement à la surface de l'emplacement de connexion (43).

4. Appareil, en particulier suivant l'une des revendications précédentes,
caractérisé par le fait
qu'un dispositif de maintien (7, 58) individuel ou commun est associé au cadre (22) d'une part et à la racle (9) d'autre part.

5. Appareil, en particulier suivant l'une des revendications précédentes,
caractérisé par le fait
que la racle (9) est maintenue déplaçable angulairement autour de son axe (59) ou en translation verticale et/ou en translation horizontale et de préférence en translation suivant une boucle (50) en particulier fermée dont la forme et la taille correspondent à la forme et à la taille de l'emplacement de connexion.

6. Appareil suivant la revendication 5, caractérisé par le fait
que la racle (9) rotative peut être bloquée de façon amovible dans une ou plusieurs, en particulier dans quatre positions angulaires.

7. Appareil suivant la revendication 5 ou 6,
caractérisé par le fait
que la racle (9) est sollicitée par une force de précontrainte contre le patron (5).

8. Appareil suivant l'une des revendications 5 à 9,
caractérisé par le fait
qu'un dispositif de guidage (9c, 22) pour le déplacement en translation sur la boucle (50) lui est associé.

9. Appareil suivant l'une des revendications précédentes,
caractérisé par le fait
que le cadre (22) est de préférence également la racle (9) est (sont) déplaçable(s) dans le dispositif de maintien (7, 65) associé entre une position de travail sur le support de circuit (4) et une position d'attente en particulier décalée vers le haut.

10. Appareil suivant l'une des revendications précédentes,
caractérisé par le fait
qu'un dispositif de grossissement (44) pour la représentation grossie d'une zone partielle ou de préférence de deux zones partielles opposées des trous de patron (5a) lui est associé, en particulier avec un dispositif de prise d'images (44b) disposé au-dessus du cadre (22) et avec un moniteur (44a).

11. Appareil suivant la revendication 10,
caractérisé par le fait
que le dispositif de prise d'images (44b) ou une optique de grossissement (47a) est monté déplaçable en translation dans une position d'attente dégageant l'espace au-dessus du cadre (22).

12. Appareil en particulier suivant l'une des revendications précédentes,
caractérisé par le fait
qu'en cas d'utilisation d'un support de circuit (4a, 4b) tridimensionnel avec des surfaces (93a, 93b) disposées transversalement ou de façon oblique les unes par rapport aux autres pour des emplacements de connexion (43), le dispositif de maintien pour le support de circuit (4b) ou le dispositif (5, 9) pour l'impression peut pivoter par rapport à l'autre et peut être positionné dans la position respective de pivotement.

13. Procédé pour l'impression d'un support de circuit (4, 4a, 4b) à l'aide de pâte de contact aux emplacements de connexion (43) pour des composants électroniques, suivant lequel la pâte de contact est étalée à l'aide d'une racle (9) sur un patron (5) maintenu dans un cadre (22), à travers des trous (5a) du patron sur le support de circuit (4, 4a, 4b),
caractérisé par le fait
qu'avec utilisation d'un cadre (22) dont la taille ne correspond qu'à une zone partielle de la surface du support de circuit, présentant les emplacements de connexion (43), ledit support de circuit est imprimé localement et, ensuite, au moins une zone partielle est imprimée ou toutes les autres zones partielles sont successivement imprimées localement.
